# EUROPEAN PATENT APPLICATION

(11) **EP 4 694 595 A1**
(43) Date of publication of application: **11.02.2026**
(21) Application number: 23929772.4
(22) Date of filing: 10.08.2023
(51) Int. Cl.: H05K 7/20

(54) **HEAT DISSIPATION DEVICE**

(30) Priority: 30.03.2023 US 202363455689 P
(71) Applicant: Delta Electronics, Inc., Taoyuan City 33341 (TW)
(72) Inventor: CHIANG, Chun-Liang, Taoyuan City, Taiwan 33341 (CN); CHIU, Hung-Nien, Taoyuan City, Taiwan 33341 (CN); OU YANG, Jhen, Taoyuan City, Taiwan 33341 (CN); SHIH, Fu-Yuan, Taoyuan City, Taiwan 33341 (CN)
(74) Representative: 2K Patentanwälte Blasberg Kewitz & Reichel
(86) International application number: PCT/CN2023/112338
(87) International publication number: WO 2024/198196

(57) **Abstract**

A heat dissipation device (100, 200), comprising a heat dissipation element (110) and a spoiler element (120). The heat dissipation element (110) has a heat dissipation surface (110T). The heat dissipation element (110) comprises a plurality of fin structures (111) located on the heat dissipation surface (110T) and protrude from the heat dissipation surface (110T). The spoiler element is joined to the heat dissipation element (110), wherein the spoiler element (120) has at least one planar part (121) and a plurality of protruding parts (122) connected to the planar part (121), and the protruding parts (122) protrude from the planar part (122) towards the heat dissipation surface (110T).

## Description

### Techinical Field

The present disclosure relates to a heat dissipation device, and in particular to a heat dissipation device provided with a spoiler element for bonding to the heat dissipation element.

### Background Technique

With the advancement of science and technology, the application of electronic devices has become more and more common. In particular, various electronic devices equipped with semiconductor components have gradually become an indispensable part of daily life. These electronic devices generate a large amount of heat energy during operation, and heat dissipation devices are currently installed on these electronic devices to maintain stable operation of the electronic devices.

However, as the performance of electronic devices improves, traditional heat dissipation devices are no longer able to maintain the operating temperature of the electronic devices within an appropriate range, which may affect the performance of the electronic devices. Therefore, how to improve the heat dissipation device to overcome the above challenges will be an urgent issue.

### Content of the Invention

Some embodiments of the present disclosure provide a heat dissipation device which includes a heat dissipation element and a spoiler element. The heat dissipation element has a heat dissipation surface and includes a plurality of fin structures that are located on and protrude from the heat dissipation surface. The spoiler element is joined to the heat dissipation element, wherein the spoiler element has at least one planar part and a plurality of protruding parts that are connected to the planar part, and the protruding parts protrude from the planar part towards the heat dissipation surface.

### Description of the Drawings

The concepts of the embodiments of the present disclosure may be better understood based on the following detailed description in conjunction with the drawings. It should be noted that, in accordance with standard practice in the industry, various features in the drawings are not necessarily drawn to scale. In fact, the dimensions of the various features may be arbitrarily expanded or reduced for clarity of illustration. Similar features are denoted by similar reference numerals throughout the specification and drawings.
FIG. 1 shows a schematic exploded view of a heat dissipation device according to some embodiments of the present disclosure;
FIG. 2 shows a schematic cross-sectional view of the heat dissipation device along the line A-A' shown in FIG. 1 according to some embodiments of the present disclosure;
FIG. 3 shows a schematic cross-sectional view of the heat dissipation device along the line A-A' shown in FIG. 1 according to some embodiments of the present disclosure;
FIG. 4 shows a schematic cross-sectional view of the heat dissipation device along the line A-A' shown in FIG. 1 according to some embodiments of the present disclosure;
FIG. 5 shows a schematic cross-sectional view of the heat dissipation device along the line A-A' shown in FIG. 1 according to some embodiments of the present disclosure;
FIG. 6 shows a schematic cross-sectional view of the heat dissipation device along the line A-A' shown in FIG. 1 according to some embodiments of the present disclosure;
FIG. 7 shows a schematic cross-sectional view of the heat dissipation device along the line A-A' shown in FIG. 1 according to some embodiments of the present disclosure;
FIG. 8A shows a schematic cross-sectional view of the heat dissipation device along the line A-A' shown in FIG. 1 according to some embodiments of the present disclosure;
FIG. 8B shows a schematic perspective view of a feature layer of a spoiler element according to some embodiments of the present disclosure;
FIG. 9 shows a schematic exploded view of the heat dissipation device according to some embodiments of the present disclosure;
FIG. 10 shows a schematic partial enlarged view of a heat dissipation element according to some embodiments of the present disclosure;
FIG. 11 shows a schematic partial enlarged view of the spoiler element according to some embodiments of the present disclosure;
FIG. 12 shows a schematic cross-sectional view of the heat dissipation device according to some embodiments of the present disclosure;
FIG. 13 shows a schematic perspective view of the heat dissipation device according to some embodiments of the present disclosure;
FIG. 14 shows a schematic perspective view of the heat dissipation device according to some embodiments of the present disclosure.

### Detailed Implementation

The heat dissipation devices of the embodiments of the present disclosure are described below. However, it can be readily appreciated that the disclosed embodiments provide many suitable creative concepts that can be embodied in a wide variety of specific backgrounds. The disclosed specific embodiments are merely illustrative of specific ways to use the disclosure and are not intended to limit the scope of the disclosure.

In addition, relative terms, such as "below" or "bottom" and "above" or "top" may be used in the embodiments to describe the relative relationship of one element to another element in the drawings. It will be understood that if the device in the drawings is flipped upside down, the elements described as being on the "lower" side would then be elements described as being on the "upper" side.

It will be understood that, although the terms "first," "second," etc. may be used herein to describe various elements, materials and/or portions, these elements, materials and/or portions should not be limited by these terms, and these terms are only used to distinguish between different elements, materials and/or portions. Thus, a first element, material and/or portion discussed below could be referred to as a second element, material and/or portion without departing from the teachings of some embodiments of the present disclosure. **In** addition, unless defined otherwise, the first or second element, material and/or portion recited in the claims may be understood as any element, material and/or portion in the specification if it complies with the description of the claims.

Unless defined otherwise, all terms (including technical and scientific terms) used herein have the same meaning as commonly understood by those skilled in the art to which this disclosure belongs. It is understood that these terms, such as those defined in commonly used dictionaries, should be interpreted to have a meaning consistent with the relevant technology and the background or context of the present disclosure, and should not be interpreted in an idealized or overly formal manner, unless specifically defined herein. In addition, the terms "substantially", "approximately" or "about" are also used herein, and are intended to cover generally consistent and completely consistent situations or ranges. It should be noted that, unless otherwise defined, even if the above terms are not described in the description, they should be interpreted in the same meaning as if these approximation terms were recited.

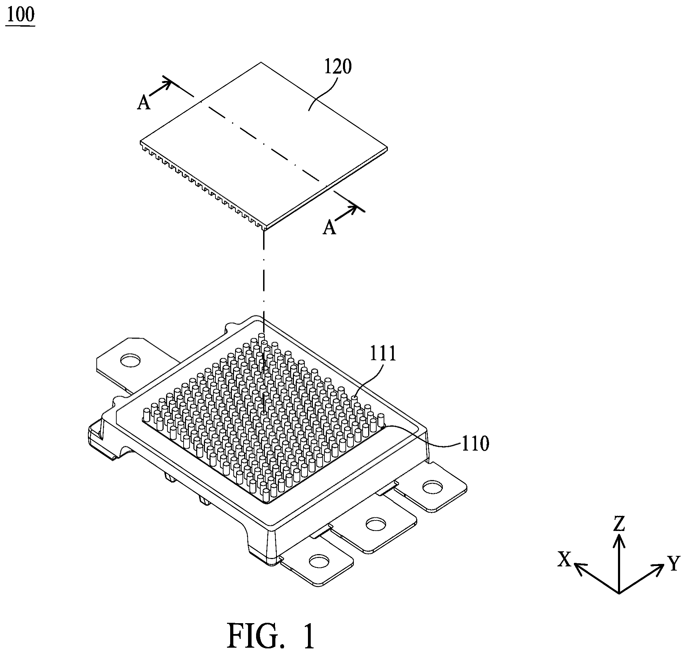

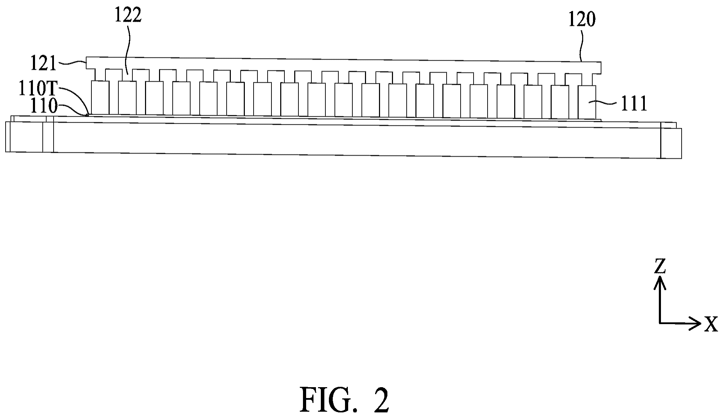

Please refer to FIG. 1 first. FIG. 1 shows a schematic exploded view of a heat dissipation device 100 according to some embodiments of the present disclosure. In some embodiments, the heat dissipation device 100 may be used, for example, in an electronic device provided with semiconductor elements or other elements that generate heat when the electronic device operates, but the present disclosure is not limited thereto. As shown in FIG. 1, the heat dissipation device 100 may include a heat dissipation element 110 and a spoiler element 120 that is joined to the heat dissipation element 110. In some embodiments, the heat dissipation element 110 is attached to a heat-generating element, such as a semiconductor element or any element that generates heat when the electronic device operates. The heat dissipation element 110 has a heat dissipation surface (for example, the heat dissipation surface 110T shown in FIG. 2), the heat dissipation surface is opposite to the surface of the heat dissipation element 110 on which a heat-generating element (not shown) is attached. In this way, the heat energy generated by the heat-generating element can be transferred from the heat dissipation surface to the external environment. In some embodiments, the heat dissipation element 110 includes a plurality of fin structures 111 that are located on the heat dissipation surface and protrude from the heat dissipation surface. In this embodiment, each of the fin structures 111 is formed as a cylindrical shape, so the fin structures 111 may also be referred to as pillar-shaped fin structures 111. With the formation of the fin structure 111, the surface area for transferring heat energy on the heat dissipation element 110 (such as on the heat dissipation surface 110T shown in FIG. 2) can be increased, thereby improving the efficiency of the heat dissipation element 110 for transferring heat energy. It should be understood that the above-mentioned shape and size of the fin structures 111 are only examples, and the present disclosure is not limited thereto. According to the present disclosure, those skilled in the art will understand that the fin structures of various shapes and sizes are encompassed by the scope of the present disclosure.

In addition, the spoiler element 120 is joined to the heat dissipation element 110 and forms a channel. For example, a coolant (not shown) may be used and flow through the channel formed by the spoiler element 120 and the heat dissipation element 110. In this way, the heat energy generated by the heat-generating element during the operation of the electronic device can be taken away by the flow of coolant, so that the electronic device can be maintained at an appropriate operating temperature and the risk of failure of the electronic device due to overheating can be reduced. For example, the above-mentioned coolant may include fluorine-containing compounds or other suitable polymer compounds, but the present disclosure is not limited thereto. It should be understood that any fluid that can be used for heat dissipation is included in the scope of the coolant described in the present disclosure.

FIG. 2 shows a schematic cross-sectional view of the heat dissipation device 100 along the line A-A' shown in FIG. 1 according to some embodiments of the present disclosure. As shown in FIG. 2, the spoiler element 120 has a planar part 121 and a plurality of protruding parts 122 that are connected to the planar part 121. In some embodiments, the planar part 121 may be parallel to a horizontal plane (for example, the X-Y plane), and the protruding parts 122 protrude from the planar part 122 toward the heat dissipation surface 110T. For example, the protruding parts 122 may extend in a direction that is perpendicular to the planar part 121 (eg, the negative Z-axis direction), but the present disclosure is not limited thereto.

In some embodiments, the protruding parts 122 of the spoiler element 120 are fixedly joined to the underlying fin structures 111. For example, the protruding parts 122 can be affixed to the underlying fin structures 111 by the techniques such as mechanical locking, tight fitting, adhesive bonding, soldering, diffusion welding, etc., but the presnet disclosure is not limited thereto. In other embodiments, techniques like 3D printing (also known as three-dimensional printing, additive manufacturing, additive manufacturing, etc.) can be used to integrally manufacture the spoiler element 120 (including the planar part 121 and the protruding parts 122) and the underlying fin structures 111. By providing the planar part 121 that interconnect the plurality of protruding parts 122 that are respectively affixed to the fin structures 111, the overall structural strength of the heat dissipation device 100 can be increased and the risk of deformation of the heat dissipation device 100 due to stress (such as thermal stress) can be reduced.

In addition, by forming the protruding parts 122 that extend toward the fin structures 111, a channel can be formed for the coolant (not shown) to flow and the coolant can be pressurized, thereby increasing the flow speed of the coolant and improving the heat dissipation efficiency of the heat dissipation device 100. Specifically, the cross-sectional area (for example, measured along the Y-Z plane) of the channel formed by the spoiler element 120 and the heat dissipation element 110 is inconsistent, so the coolant will be pressurized when flowing through the narrower part of the channel, and the flow speed of the coolant is increased.

For example, the spoiler element 120 may be made of a metal material with high thermal conductivity, such as copper, aluminum, alloys containing copper or aluminum, other suitable materials, or a combination thereof. **In** this way, the heat dissipation efficiency of the heat dissipation device 100 can be further improved. **In** some embodiments, the spoiler element 120 may be made of an easily moldable polymer material, such as plastic. **In** this way, the difficulty of manufacturing the heat dissipation device 100 can be reduced. It should be understood that the spoiler element 120 may be made of a single material or include multiple different materials, and all possible material configurations are within the scope of the present disclosure. For example, the planar part 121 and the protruding parts 122 of the spoiler element 120 can be made of different materials to take all the advantages of the above materials into account. In an embodiment in which the planar part 121 and the protruding part 122 are made of different materials, the planar part 121 and the protruding parts 122 may affixed by mechanical locking, tight fitting, adhesive bonding, soldering, diffusion welding and other techniques, but the present disclosure is not limited thereto.

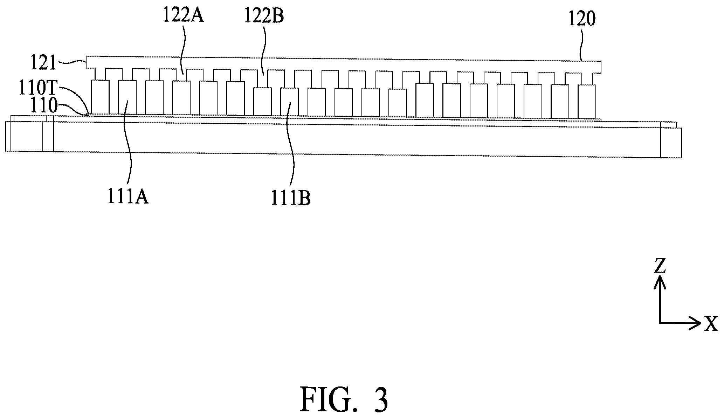

FIG. 3 shows a schematic cross-sectional view of the heat dissipation device 100 along the line A-A' shown in FIG. 1 according to some embodiments of the present disclosure. It should be noted that the heat dissipation device 100 in this embodiment may include elements that are the same as or similar to those of the heat dissipation device 100 shown in FIG. 2. These elements are denoted by the same or similar reference numerals and will not be described in detail below. As shown in FIG. 3, the heat dissipation device 100 may include a heat dissipation element 110 and a spoiler element 120 that is joined to the heat dissipation element 110. Specifically, the difference between this embodiment and the heat dissipation device 100 shown in FIG. 2 is that the heat dissipation element 110 includes first fin structures 111A and second fin structures 111B with different lengths. Similarly, the spoiler element 120 includes first protruding parts 122A and second protruding parts 122B with different lengths. For example, the above-mentioned length may be measured along a direction that is parallel to the Z-axis, but the present disclosure is not limited thereto.

In some embodiments, the first fin structures 111A are joined to the corresponding first protruding parts 122A, and the second fin structures 111B are joined to the corresponding second protruding parts 122B. In this embodiment, the sum of the lengths of the first protruding parts 122A and the first fin structures 111A is approximately equal to the sum of the lengths of the second protruding parts 122B and the second fin structures 111B, so that the planar part 121 of the spoiler element 120 is substantially parallel to the horizontal plane (for example, the X-Y plane). In some embodiments, the length of the second fin structures 111B is less than the length of the first fin structures 111A, and the second fin structures 111B are located at the center of the heat dissipation element 110, but the presnet disclosure is not limited thereto.

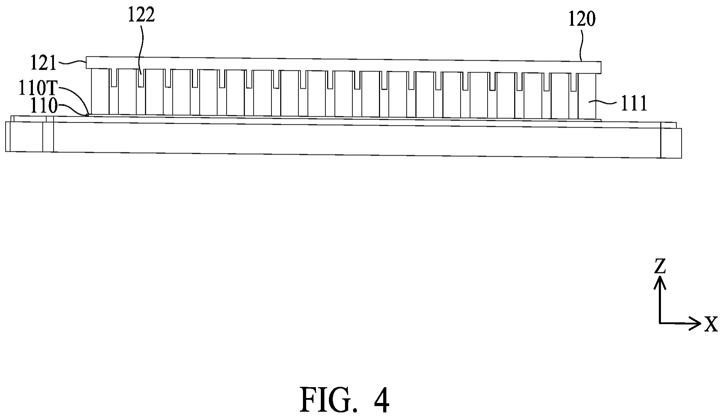

FIG. 4 shows a schematic cross-sectional view of the heat dissipation device 100 along the line A-A' shown in FIG. 1 according to some embodiments of the present disclosure. It should be noted that the heat dissipation device 100 in this embodiment may include elements that are the same as or similar to those of the heat dissipation device 100 shown in FIG. 2. These elements are denoted by the same or similar reference numerals and will not be described in detail below. As shown in FIG. 4, the heat dissipation device 100 may include a heat dissipation element 110 and a spoiler element 120 that is joined to the heat dissipation element 110. Specifically, the difference between this embodiment and the heat dissipation device 100 shown in FIG. 2 is that the planar part 121 of the spoiler element 120 is fixedly connected to the underlying fin structures 111. For example, the planar part 121 can be affixed to the underlying fin structures 111 by techniques such as mechanical locking, tight fitting, adhesive bonding, soldering, diffusion welding, etc., but the present disclosure is not limited thereto. In other embodiments, techniques like 3D printing (also known as three-dimensional printing, additive manufacturing, additive manufacturing, etc.) can be used to integrally manufacture the spoiler element 120 and the underlying fin structures 111. By fixing the planar part 121 to the underlying fin structures 111, the overall structural strength of the heat dissipation device 100 can be increased and the risk of deformation of the heat dissipation device 100 due to stress (such as thermal stress) can be reduced.

In addition, the protruding parts 122 of the spoiler element 120 are disposed in the gaps between two adjacent fin structures 111. For example, in this embodiment, one protruding part 122 is disposed between any two adjacent fin structures 111, but the present disclosure is not limited thereto. In some other embodiments, there may not be any protruding part 122 between two adjacent fin structures 111, or there may be multiple protruding parts 122 therebetween. These possible configurations are all within the scope of the present disclosure. Furthermore, in some embodiments, the sidewalls of the protruding parts 122 may contact the sidewalls of the fin structures 111. In some other embodiments, a gap may be formed between the sidewalls of the protruding parts 122 and the sidewalls of the fin structures 111. In this way, the overall thickness of the heat dissipation device 100 in the Z-axis can be further reduced, thereby achieving miniaturization. With the above design, the coolant can be pressurized in the channel, so that the flow speed of the coolant is increased, thereby improving the overall heat dissipation efficiency of the heat dissipation device 100.

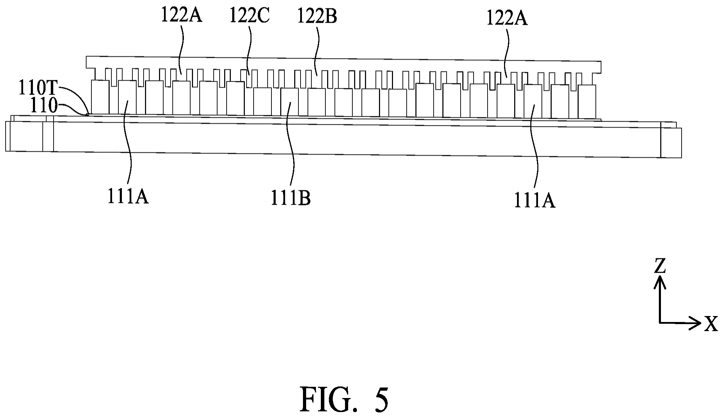

FIG. 5 shows a schematic cross-sectional view of the heat dissipation device 100 along the line A-A' shown in FIG. 1 according to some embodiments of the present disclosure. It should be noted that the heat dissipation device 100 in this embodiment may include elements that are the same as or similar to those of the heat dissipation device 100 shown in FIG. 3. These elements are denoted by the same or similar reference numerals and will not be described in detail below. As shown in FIG. 5, the heat dissipation device 100 may include a heat dissipation element 110 and a spoiler element 120 that is joined to the heat dissipation element 110. Specifically, the difference between this embodiment and the heat dissipation device 100 shown in FIG. 3 is that the spoiler element 120 also includes third protruding parts 122C that are located between two adjacent first protruding parts 122A (or between the second protruding parts 122B). The third protruding parts 122C can be disposed in the gap between two adjacent fin structures 111. For example, in this embodiment, a third protruding part 122C is disposed between any two adjacent fin structures 111, but the presnt disclosure is not limited thereto. **In** some other embodiments, there may not be any protruding part 122 between two adjacent fin structures 111, or there may be multiple protruding parts 122 therebetween, and these possible configurations are all within the scope of the present disclosure. With the above design, the coolant can be pressurized in the channel, so that the flow speed of the coolant is increased, thereby improving the overall heat dissipation efficiency of the heat dissipation device 100.

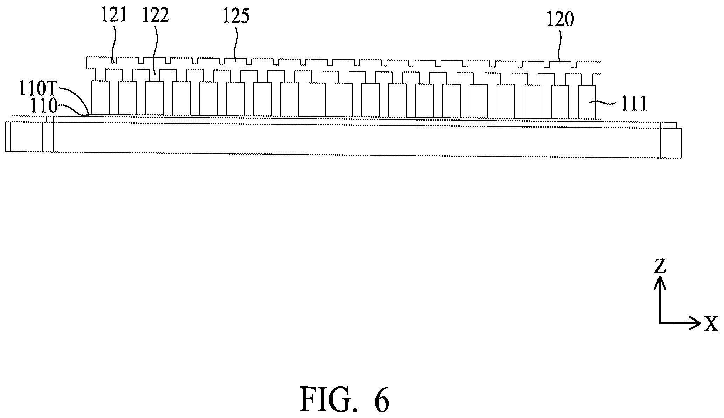

FIG. 6 shows a schematic cross-sectional view of the heat dissipation device 100 along the line A-A' shown in FIG. 1 according to some embodiments of the present disclosure. It should be noted that the heat dissipation device 100 in this embodiment may include elements that are the same as or similar to those of the heat dissipation device 100 shown in FIG. 2. These elements are denoted by the same or similar reference numerals and will not be described in detail below. As shown in FIG. 6, the heat dissipation device 100 may include a heat dissipation element 110 and a spoiler element 120 that is joined to the heat dissipation element 110. Specifically, the difference between this embodiment and the heat dissipation device 100 shown in FIG. 2 is that the spoiler element 120 further has a plurality of additional protruding parts 125 that are connected to the planar part 121, and the additional protruding parts 125 protrude from the planar part 121 and away from the heat dissipation surface 110T. **In** other words, the additional protruding parts 125 and the protruding parts 122 are respectively located on opposite sides of the planar part 121. With the above design, the turbulence of the coolant can be increased in and outside the channel, thereby improving the heat exchange capacity of the coolant, so that the overall heat dissipation efficiency of the heat dissipation device 100 is improved. **In** some embodiments, the width of each of additional protruding parts 125 may be greater than the width of each of the protruding parts 122. The above-mentioned width may be measured along the X-axis, for example, but the present disclosure is not limited thereto. **In** other embodiments, the width of each of the additional protruding parts 125 may be less than or equal to the width of each of the protruding parts 122.

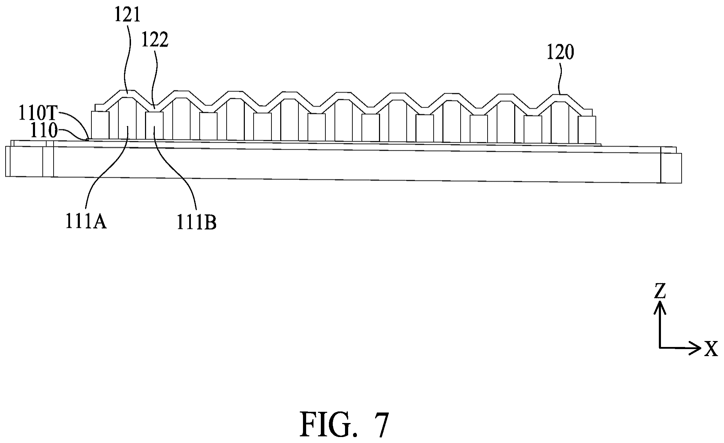

FIG. 7 shows a schematic cross-sectional view of the heat dissipation device 100 along the line A-A' shown in FIG. 1 according to some embodiments of the present disclosure. It should be noted that the heat dissipation device 100 in this embodiment may include elements that are the same as or similar to those of the heat dissipation device 100 shown in FIG. 2. These elements are denoted by the same or similar reference numerals and will not be described in detail below. As shown in FIG. 7, the heat dissipation device 100 may include a heat dissipation element 110 and a spoiler element 120 that is joined to the heat dissipation element 110. Specifically, the difference between this embodiment and the heat dissipation device 100 shown in FIG. 2 is that the heat dissipation element 110 includes first fin structures 111A and second fin structures 111B with different lengths. For example, the above-mentioned lengths may be measured along a direction that is parallel to the Z-axis, but the present disclosure is not limited thereto.

The first fin structures 111A and the second fin structures 111B may be alternately disposed and joined to the planar parts 121 and the protruding parts 122 of the spoiler element 120, respectively. For example, the first fin structures 111A may be joined to the planar parts 121, and the second fin structures 111B, which are shorter than the first fin structures 111A in length, may be joined to the protruding parts 122. In this embodiment, the spoiler element 120 has a plurality of planar parts 121 that are not in direct contact with each other (for example, a gap will be formed between adjacent planar parts 121 in the horizontal direction (such as the X-axis)). The protruding parts 122 of the spoiler element 120 extend obliquely from the adjacent planar parts 121 to form V-shaped protruding structures. In some embodiments, the protruding parts 122 of the spoiler element 120 can also extend vertically from the adjacent planar parts 121 to form U-shaped protruding structures. However, the present disclosure is not limited to the above-mentioned shape of the protruding part 122, and any shape of the protruding parts 122 that can connect adjacent planar parts 121 is included within the scope of the present disclosure. With the above design, the manufacturing cost of the spoiler element 120 can be further reduced, and meanwhile, the heat dissipation efficiency of the heat dissipation device 100 can be improved.

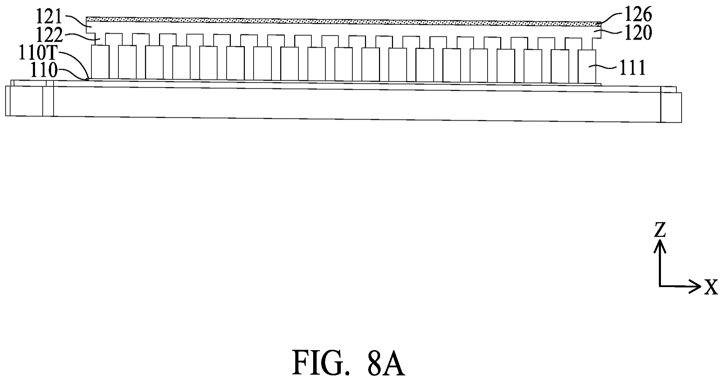

FIG. 8A shows a schematic cross-sectional view of the heat dissipation device 100 along the line A-A' shown in FIG. 1 according to some embodiments of the present disclosure. It should be noted that the heat dissipation device 100 in this embodiment may include elements that are the same as or similar to those of the heat dissipation device 100 shown in FIG. 2. These elements are denoted by the same or similar reference numerals and will not be described in detail below. As shown in FIG. 8A, the heat dissipation device 100 may include a heat dissipation element 110 and a spoiler element 120 that is joined to the heat dissipation element 110. Specifically, the difference between this embodiment and the heat dissipation device 100 shown in FIG. 2 is that the spoiler element 120 further has a characteristic layer 126 that is located on the surface of the spoiler element 120 opposite to the protruding part 122 (i.e., the surface away from the fin structures 111).

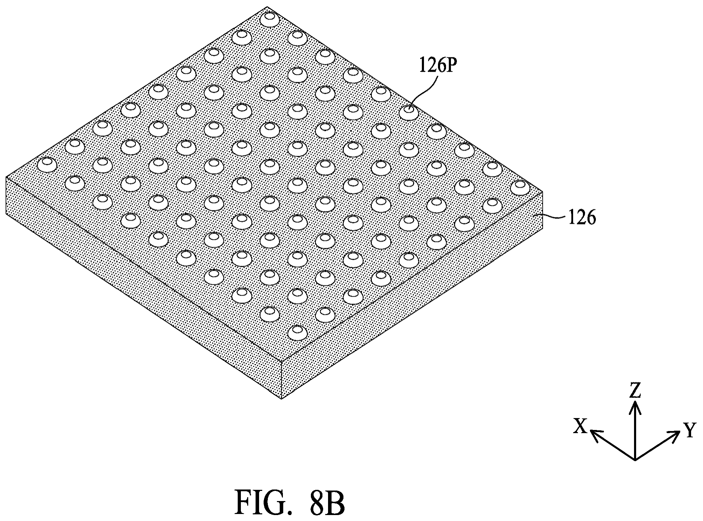

FIG. 8B shows a perspective view of the feature layer 126 of the spoiler element 120 according to some embodiments of the present disclosure. As shown in FIG. 8B, a plurality of bumps 126P may be formed on the feature layer 126. With the above design, the turbulence of the coolant can be increased over the spoiler element 120, thereby improving the heat exchange capacity of the coolant, and improving the overall heat dissipation efficiency of the heat dissipation device 100. In other embodiments, multiple recesses (not shown) may be formed on the feature layer 126, achieving the effect the same as forming the bumps 126P. It should be understood that although the bumps 126P are arranged in a matrix in this embodiment, other embodiments in which the bumps 126P are arranged in any other regular or irregular manner are also included within the scope of the present disclosure.

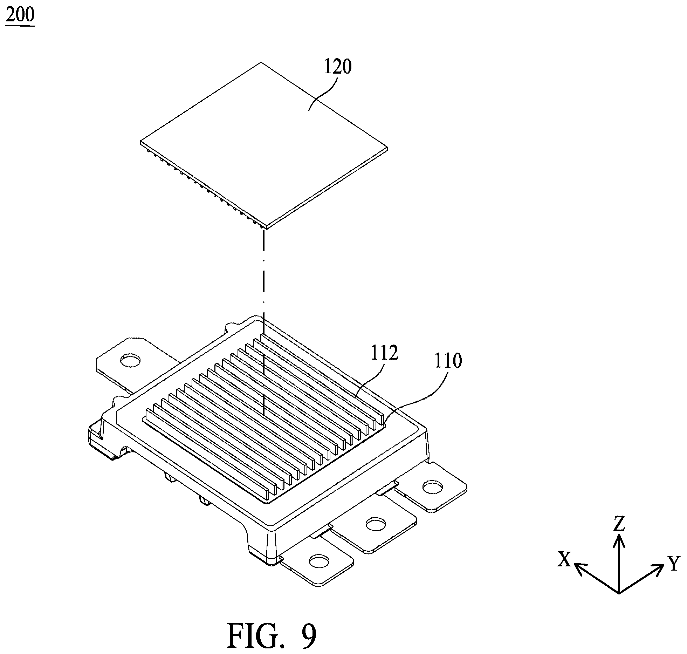

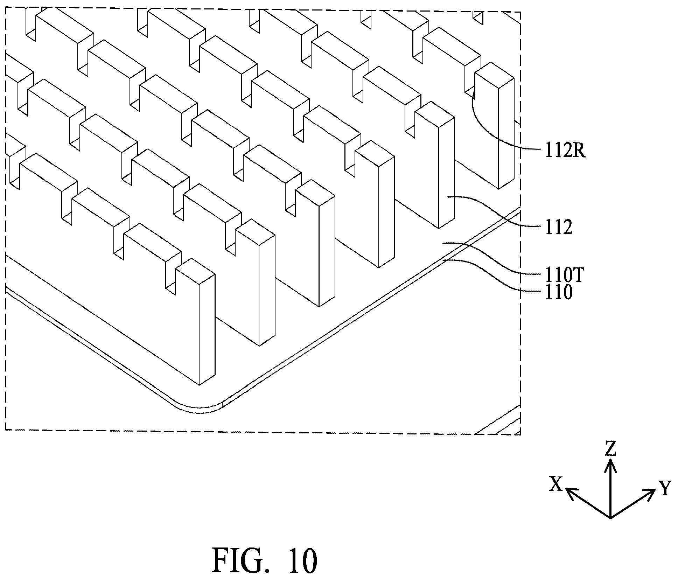

FIG. 9 shows a schematic exploded view of a heat dissipation device 200 according to some embodiments of the present disclosure. The heat dissipation device 200 in this embodiment may include elements that are the same as or similar to those of the heat dissipation device 100 shown in FIG. 1. These elements are denoted by the same or similar reference numerals and will not be described in detail below. As shown in FIG. 9, the heat dissipation device 200 may include a heat dissipation element 110 and a spoiler element 120 that is joined to the heat dissipation element 110. Specifically, the difference between the heat dissipation device 200 of this embodiment and the heat dissipation device 100 shown in FIG. 1 is that the heat dissipation element 110 includes a plurality of fin structures 112 that are located on a heat dissipation surface (such as the heat dissipation surface 110T shown in FIG. 10) and protrude from the heat dissipation surface. In this embodiment, the fin structures 112 are each formed as sheet-shaped, so the fin structures 112 may also be referred to as sheet-shaped fin structures 111. With the formation of the fin structures 112, the surface area for transferring heat energy on the heat dissipation element 110 (such as on the heat dissipation surface 110T shown in FIG. 10) can be increased, thereby improving the efficiency of the heat dissipation element 110 for transferring heat energy. It should be understood that the above-mentioned shape and size of the fin structure 112 are only examples, and the present disclosure is not limited thereto. According to the present disclosure, those skilled in the art will understand that the fin structures of various shapes and sizes are included with the scope of the present disclosure.

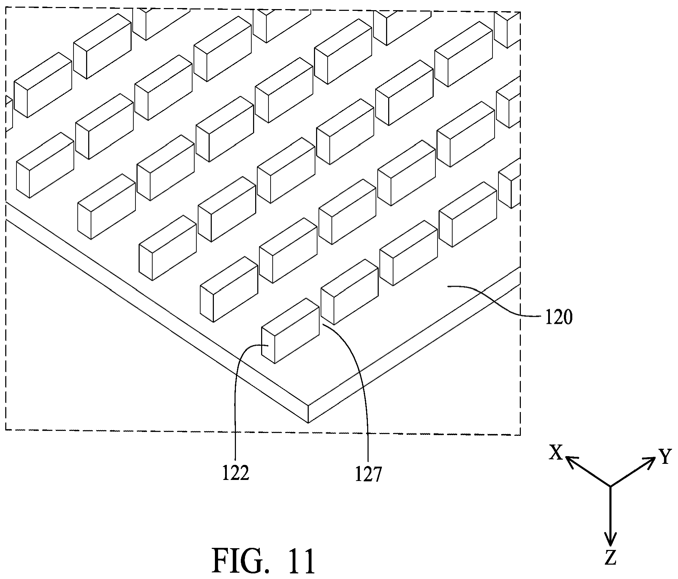

FIG. 10 shows a schematic partial enlarged view of the heat dissipation element 110 according to some embodiments of the present disclosure. As shown in FIG. 10, a plurality of receiving grooves 112R are formed on each of the fin structures 112. In some embodiments, the depth of the receiving grooves 112R may be less than the height of the fin structures 112 (for example, measured along the Z-axis). That is, the receiving groove 112R does not separate the fin structures 112 into multiple discrete parts, but the present disclosure is not limited thereto. With the arrangement of the receiving grooves 112R, it may be advantageous to bond the protruding parts 122 (referring to, for example, FIG. 11) to the fin structures 112.

FIG. 11 shows a schematic partial enlarged view of the spoiler element 120 according to some embodiments of the present disclosure. A plurality of receiving grooves 127 are formed on each of the protruding parts 122. In some embodiments, the depth of the receiving grooves 127 may be substantially equal to the height of the protruding parts 122 (for example, measured along the Z-axis). That is, the receiving grooves 127 may separate the protruding parts 122 into multiple discrete parts. However, the present disclosure is not limited thereto. The arrangement of the receiving grooves 127 facilitates bonding the fin structures 112 to the protruding parts 122, for example, aligning the receiving grooves 112R on the fin structures 112 with the receiving grooves 127 on the protruding parts 122, respectively. As set forth above, the receiving grooves 112R can be formed on the fin structures 112 and the receiving grooves 127 can be formed on the protruding parts 122 at the same time, but the present disclosure is not limited thereto. Either of the receiving grooves 112R or the receiving grooves 127 can be selectively formed, or the receiving groove 112R and the receiving groove 127 can be omitted, thereby reducing the manufacturing cost and time of the heat dissipation device 100.

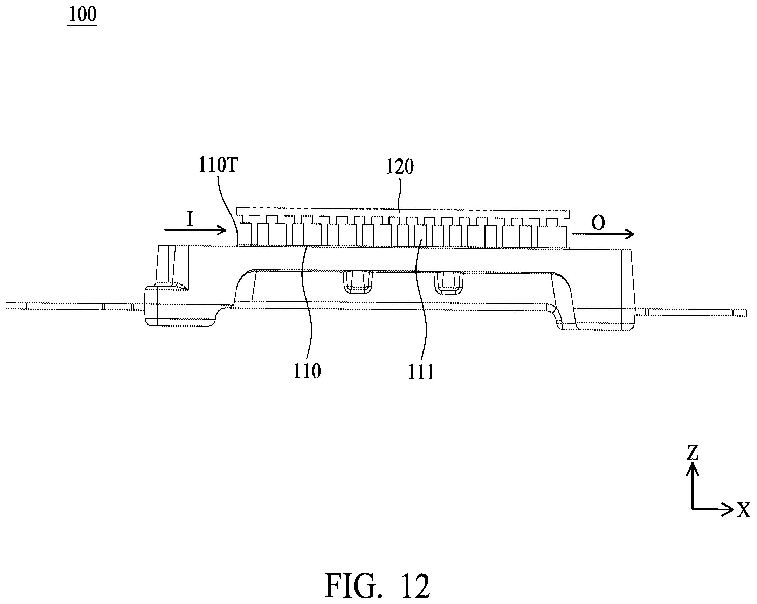

FIG. 12 shows a schematic side view of the heat dissipation device 100 according to some embodiments of the present disclosure. As shown in FIG. 12, the coolant can be used and flow into the channel formed by the spoiler element 120 and the heat dissipation element 110 in a direction **I,** and flow out of the channel in a direction O. **In** some embodiments, the direction I and the direction O can be any direction parallel to the X-Y plane. **In** this way, the heat energy generated by the heat-generating element during the operation of the electronic device can be taken away by the flow of coolant, so that the electronic device can be maintained at an appropriate operating temperature and the risk of failure of the electronic device due to overheating can be reduced. For example, the above-mentioned coolant may include fluorine-containing compounds or other suitable polymer compounds, but the present disclosure is not limited thereto.

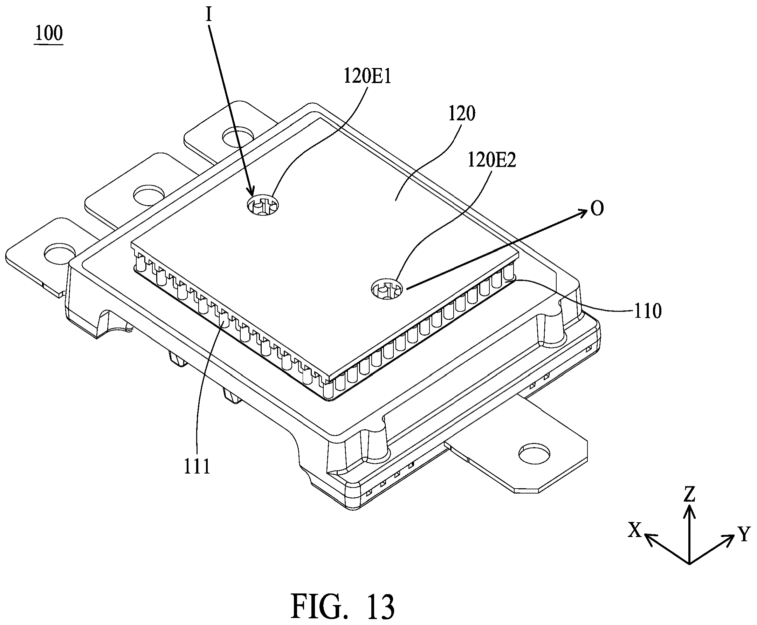

FIG. 13 shows a schematic perspective view of the heat dissipation device 100 according to some embodiments of the present disclosure. The heat dissipation device 100 in this embodiment may include elements that are the same as or similar to those of the heat dissipation device 100 shown in FIG. 12. These elements are denoted by the same or similar reference numerals and will not be described in detail below. As shown in FIG. 13, the heat dissipation device 100 may include a heat dissipation element 110 and a spoiler element 120 that is joined to the heat dissipation element 110. Specifically, the difference between this embodiment and the heat dissipation device 100 shown in FIG. 12 is that a first opening 120E1 and a second opening 120E2 are formed to penetrate the spoiler element 120, so the first opening 120E1 and the second opening 120E2 will expose a portion of the fin structures 111 on the heat dissipation surface. In this embodiment, the coolant may be used and flowed into the first opening 120E1 along the direction I, and flow out of the second opening 120E2 along the direction O. In some embodiments, the direction I and the direction O may be any direction that is not parallel to the X-Y plane. With the arrangement of the first opening 120E1 and the second opening 120E2, the effect of changing the flow direction of the coolant can be achieved, so that the heat dissipation device 100 can meet the needs of the users.

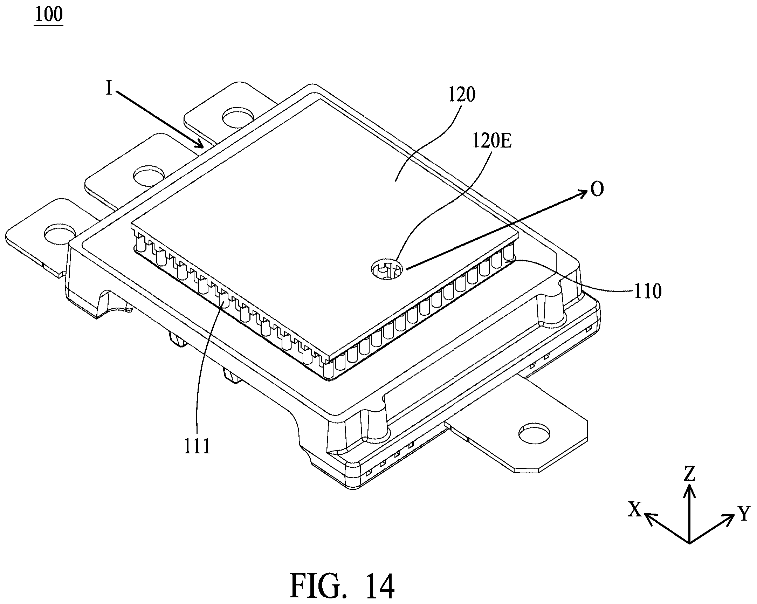

FIG. 14 shows a schematic perspective view of the heat dissipation device 100 according to some embodiments of the present disclosure. The heat dissipation device 100 in this embodiment may include elements that are the same as or similar to those of the heat dissipation device 100 shown in FIG. 12. These elements are denoted by the same or similar reference numerals and will not be described in detail below. As shown in FIG. 14, the heat dissipation device 100 may include a heat dissipation element 110 and a spoiler element 120 that is joined to the heat dissipation element 110. Specifically, the difference between this embodiment and the heat dissipation device 100 shown in FIG. 12 is that an opening 120E is formed to penetrate the spoiler element 120, so the opening 120E will expose a part of the fin structures 111 on the heat dissipation surface. In this embodiment, the coolant may be used and flow into the channel formed by the spoiler element 120 and the heat dissipation element 110 along the direction I, and flow out of the opening 120E along the direction O. In some embodiments, the direction I may be any direction that is parallel to the X-Y plane, and the direction O may be any direction that is not parallel to the X-Y plane, but the present disclosure is not limited thereto. In some embodiments, the directions I and O may be exchanged, that is, the coolant may flow into the opening 120E and flow in along the direction I and out of the channel formed by the spoiler element 120 and the heat dissipation element 110. With the arrangement of the opening 120E, the effect of changing the flow direction of the coolant can be achieved, so that the heat dissipation device 100 can meet the needs of the users.

**In** summary, the present disclosure provides a heat dissipation device provided with a spoiler element to be joined to a heat dissipation element. Specifically, by arranging the spoiler element joined to the fin structures, the overall structural strength of the heat dissipation device can be increased, and the risk of deformation of the heat dissipation device due to stress (such as thermal stress) can be reduced. Furthermore, the coolant flowing through the channel can be pressurized to increase the flow speed of the coolant and enhance the heat dissipation efficiency of the heat dissipation device. **In** addition, the spoiler element can be made of a metal material with high thermal conductivity or an easily moldable polymer material. **In** this way, the heat dissipation efficiency of the heat dissipation device can be further improved, or the difficulty of manufacturing the heat dissipation device can be reduced.

However, the embodiments and advantages of the present disclosure have been disclosed above, but it should be understood that any of those skilled in the art can make changes, substitutions and modifications without departing from the spirit and scope of the present disclosure. **In** addition, the protection scope of the present disclosure is not limited to the processes, machines, manufacturing, material compositions, devices, methods and steps in the specific embodiments described in the specification. Any of those skilled in the art can understand from the present disclosure that processes, machines, manufacturing, material compositions, devices, methods and steps existing or developed in the future can be used according to the present disclosure as long as they can perform substantially the same functions or obtain substantially the same results in the embodiments described herein. Therefore, the protection scope of the present disclosure includes the above-mentioned processes, machines, manufacturing, material compositions, devices, methods and steps, and the features of various embodiments can be mixed and matched as long as they do not violate the spirit of creation or conflict with each other. In addition, each claim constitutes an individual embodiment, and the protection scope of the present disclosure also includes the combination of respective claims and embodiments.

### Explanation of reference numbers

100, 200: heat dissipation device
110: heat dissipation element
110T: heat dissipation surface
111: fin structure (pillar-shaped fin structure)
111A: first fin structure
111B: second fin structure
112: fin structure (sheet-shaped fin structure)
112R: bonding groove
120: spoiler element
120E: opening
120E1: first opening
120E2: second opening
121: planar part
122: protruding part
122A: first protruding part
122B: second protruding part
122C: third protruding part
125: additional protruding part
126: feature layer
126P: bump
127: bonding groove
A-A: line
I, O: direction

## Claims

1. A heat dissipation device, comprising:
a heat dissipation element having a heat dissipation surface, wherein the heat dissipation element comprises a plurality of fin structures located on and protruding from the heat dissipation surface; and
a spoiler element joined to the heat dissipation element, wherein the spoiler element has at least one planar part and a plurality of protruding parts connected to the at least one planar part, and the plurality of protruding parts protrude from the at least one planar part towards the heat dissipation surface.

2. The heat dissipation device according to claim 1, wherein each of the plurality of protruding parts is joined to at least one of the plurality of fin structures.

3. The heat dissipation device according to claim 1, wherein the plurality of protruding parts comprise a plurality of first protruding parts and a plurality of second protruding parts, and a length of the plurality of first protruding parts is different from a length of the plurality of second protruding parts.

4. The heat dissipation device according to claim 3, wherein the plurality of fin structures comprise a plurality of first fin structures joined to the plurality of first protruding parts and a plurality of second fin structures joined to the plurality of second protruding parts, and a sum of the length of the plurality of first protruding parts and a length of the plurality of first fin structures is equal to a sum of the length of the plurality of second protruding parts and a length of the plurality of second fin structures.

5. The heat dissipation device according to claim 1, wherein the at least one planar part of the spoiler element is joined to the plurality of fin structures, and the plurality of protruding parts are each located between adjacent two of the plurality of fin structures.

6. The heat dissipation device according to claim 1, wherein the spoiler element further has a plurality of additional protruding parts connected to the at least one planar part, the plurality of additional protruding parts protrude from the at least one planar part away from the heat dissipation surface.

7. The heat dissipation device according to claim 1, wherein the spoiler element has a plurality of planar parts that are not in direct contact with each other, and the plurality of protruding parts of the spoiler element extend from adjacent two of the plurality of planar parts.

8. The heat dissipation device according to claim 1, wherein the spoiler element further has a feature layer located on a surface of the spoiler element, the surface is opposite to the plurality of protruding parts, and a plurality of bumps or a plurality of recesses are formed on the feature layer.

9. The heat dissipation device according to claim 1, wherein a plurality of receiving grooves are formed on the plurality of fin structures of the heat dissipation element or on the plurality of protruding parts of the spoiler element.

10. The heat dissipation device according to claim 1, wherein at least one opening is formed to penetrate the spoiler element and expose a portion of the plurality of fin structures on the heat dissipation surface.
